# EUROPEAN PATENT SPECIFICATION

(11) **EP 4 113 636 B1**
(45) Date of publication and mention of the grant of the patent: **07.02.2024**
(21) Application number: 21213760.8
(22) Date of filing: 10.12.2021
(51) Int. Cl.: H01L 31/18

(54) **DEVICE AND METHOD FOR REPAIRING PHOTOVOLTAIC CELL STRING**
VORRICHTUNG UND VERFAHREN ZUR REPARATUR EINES PHOTOVOLTAISCHEN ZELLENSTRANGS
DISPOSITIF ET PROCÉDÉ DE RÉPARATION DE CHAÎNE DE CELLULE PHOTOVOLTAÏQUE

(30) Priority: 30.06.2021 CN 202110739534
(43) Date of publication of application: 04.01.2023
(73) Proprietor: JINKO SOLAR CO., LTD, Jiangxi 334100 (CN); Zhejiang Jinko Solar Co., Ltd., Haining, Zhejiang 314416 (CN)
(72) Inventor: LI, Tingting, Haining, Zhejiang, 314416 (CN); TAO, Wusong, Haining, Zhejiang, 314416 (CN); QI, Peidong, Haining, Zhejiang, 314416 (CN)
(74) Representative: Rösler Rasch van der Heide & Partner

(56) References cited:
- EP-A1- 2 822 044
- EP-A1- 3 016 147
- CN-B- 108 574 023
- KR-A- 20160 038 990
- US-A1- 2007 283 995
- US-A1- 2017 229 602

## Description

### TECHNICAL FIELD

The present disclosure relates to the technical field of photovoltaic cell manufacturing, and in particular, to a device and method for repairing photovoltaic cell string.

### BACKGROUND

A photovoltaic cell string is composed of a plurality of photovoltaic cells successively connected by soldering. Each solar cell is provided with a back side and a protruding solder strip extending from a side surface of the back side. The plurality of solar cells are sequentially connected, and the protruding solder strip of each solar cell is connected to the back side of a next solar cell. During actual manufacturing of solar cells, a main bottleneck of productivity and yield lies in a repair process of solar cell strings, especially repair of micro-cracks.

In the related art, the solar cell strings are often repaired manually. Specifically, damaged defective solar cells are required to be desoldered manually, the defective solar cells are removed from the solar cell strings, and then non-defective solar cells are connected to the solar cell strings by soldering, which results in low efficiency, poor satisfaction and high repair costs, and thus goes against cost reduction and efficiency increase of manufacturers.
CN108574023B is directed to a device for repairing a photovoltaic cell string including a working platform, a desoldering device, and a resoldering device. The desoldering device includes a cutting thread for disconnecting the defective solar cell from the photovoltaic cell string. The resoldering device includes a heading plate.
EP3016147A1 is directed to a method and a device for repairing the solar cell module. A plurality of wiring members electrically connecting the defective solar cell are cut by heating of an ultraviolet lamp. The new solar cell is soldered to the solar cell module by heating.

### SUMMARY

The present disclosure provides a device and method for repairing photovoltaic cell string. The device is as defined in claim 1. The method is as defined in claim 9. Preferred features are defined in the dependent claims.

In a first aspect, the present disclosure provides a device for repairing photovoltaic cell string, including: a conveying device configured to drive a photovoltaic cell string placed on the conveying device to reciprocate along a first direction, and a baking device arranged toward the second conveying component. The conveying device includes a first conveying component, a second conveying component and a third conveying component that are separately arranged. The baking device is configured to heat the photovoltaic cell string located on the second conveying component, so that a protruding solder strip of a solar cell in the photovoltaic cell string is separated or fused at its connecting part.

In one or more embodiments, the device further includes a fixing device, the fixing device including a press tool and a compression drive connected to each other, the press tool is located between the baking device and the second conveying component. The press tool is configured to compress the photovoltaic cell string against a non-defective solar cell for replacement at a position of the protruding solder strip and the corresponding back side.

In one or more embodiments, the first conveying component and/or the third conveying component is provided with a lift drive, the lift drive is configured to drive the first conveying component and/or the third conveying component to reciprocate along a vertical direction. The vertical direction is perpendicular to the first direction.

In one or more embodiments, the first conveying component includes a first base plate, a first belt arranged around the first base plate, and a first drive for driving the first belt to rotate around the first base plate; or the second conveying component includes a second base plate, a second belt arranged around the second base plate, and a second drive for driving the second belt to rotate around the second base plate; or the third conveying component includes a third base plate, a third belt arranged around the third base plate, and a third drive for driving the third belt to rotate around the third base plate.

In one or more embodiments, at least one of the first base plate, the second base plate or the third base plate is provided with a negative pressure suction hole, at least one of the first belt, the second belt or the third belt is provided with a negative pressure via communicated with the negative pressure suction hole, the negative pressure suction hole is communicated with an external negative pressure device, and the negative pressure suction hole is configured to generate negative pressure to suck the photovoltaic cell string on at least one of the first belt, the second belt or the third belt.

In one or more embodiments, the baking device includes a baking heater and a baking lift connected to each other, the baking lift is configured to drive the baking heater to move along a vertical direction.

In one or more embodiments, the baking heater includes a plurality of lamp tubes separately arranged and spaced along the first direction.

In one or more embodiments, the device further includes a control device electrically connected to the conveying device and the baking device, wherein the control device is configured to control a conveying stroke and a conveying direction of the conveying device, and is further configured to control ON and OFF of the baking device.

In one or more embodiments, a length of the conveying stroke is an integer multiple of a length of an orthographic projection of a single solar cell in the photovoltaic cell string in the first direction.

In a second aspect, the present disclosure further provides a method for repairing photovoltaic cell string, including: a feeding step, a desoldering step and a welding step. The feeding step includes: a photovoltaic cell string is composed of a plurality of solar cells that are sequentially connected, connecting a protruding solder strip on each of the plurality of solar cells to a back side of a next one of the plurality of solar cells, placing the photovoltaic cell string on a conveying device, and locating the back sides of the plurality of solar cells in the photovoltaic cell string on one side close to a baking device. The plurality of solar cells include at least one defective solar cell. The conveying device includes a first conveying component. A second conveying component and a third conveying component that are arranged separately and capable of driving the photovoltaic cell string to reciprocate along a first direction, and the baking device is arranged above the second conveying component. The desoldering step includes: driving, by the conveying device, the photovoltaic cell string to move along the first direction to enable a protruding solder strip and a back side of the defective solar cell to be located below the baking device, and heating by the baking device to enable the photovoltaic cell string to be decomposed into a first solar cell string, the defective solar cell and a second solar cell string. The welding step includes: driving, by the conveying device, the first solar cell string and the second solar cell string to move, placing a non-defective solar cell for replacement on the conveying device, so that the non-defective solar cell abuts against the first solar cell string and the second solar cell string, and driving, by the conveying device, a protruding solder strip and a back side of the non-defective solar cell to be located below the baking device, and heating by the baking device to enable the first solar cell string, the non-defective solar cell and the second solar cell string to be connected.

In one or more embodiments, a solar cell in the first solar cell string connected to the defective solar cell is a first solar cell, a solar cell in the second solar cell string connected to the defective solar cell is a second solar cell, and the desoldering step further includes: driving, by the conveying device, the photovoltaic cell string to move along the first direction, locating the protruding solder strip of the defective solar cell in a baking station between the baking device and the second conveying component, heating by the baking device to enable the defective solar cell to be separated from the first solar cell; and driving, by the conveying device, the second solar cell string to move along the first direction, and locating the back side of the defective solar cell in the baking station, heating by the baking device to enable the defective solar cell to be separated from the second solar cell, and driving, by the third conveying component or the first conveying component, the second solar cell string to move along the first direction away from the defective solar cell, to detach a protruding solder strip of the second solar cell from the back side of the defective solar cell.

In one or more embodiments, the welding step further includes: driving, by the first conveying component or the third conveying component, the first solar cell string to move, so that the first solar cell is located at the baking station, placing the non-defective solar cell and enabling the protruding solder strip thereof to abut against a back side of the first solar cell, and heating by the baking device to enable the non-defective solar cell to be connected to the first solar cell string; and driving, by the first conveying component or the third conveying component, the first solar cell string to move, so that the back side of the non-defective solar cell is located at the baking station, and driving, by the third conveying component or the first conveying component, the second solar cell string to move in the first direction, so that the protruding solder strip of the second solar cell abuts against the back side of the non-defective solar cell, and heating by the baking device to enable the non-defective solar cell to be connected to the second solar cell string.

In one or more embodiments, the welding step further includes: placing the non-defective solar cell and enabling the protruding solder strip thereof to abut against a back side of the first solar cell, and heating by the baking device to enable the non-defective solar cell to be connected to the first solar cell string; and driving, by the first conveying component or the third conveying component, the first solar cell string to move, so that the back side of the non-defective solar cell is located at the baking station, and driving, by the third conveying component or the first conveying component, the second solar cell string to move in the first direction, so that the protruding solder strip of the second solar cell abuts against the back side of the non-defective solar cell, and heating by the baking device to enable the non-defective solar cell to be connected to the second solar cell string.

In one or more embodiments, the method for repairing photovoltaic cell string further includes a combining step: after the first conveying component or the third conveying component drives the first solar cell string to move to enable the non-defective solar cell for replacement to be located at the baking station, driving, by the lift drive, the third conveying component or the first conveying component to move by a distance Y along a vertical direction close to the baking device; and driving, by the third conveying component or the first conveying component, the second solar cell string to move along the first direction close to the first solar cell string, until the protruding solder strip of the second solar cell is located above the non-defective solar cell, and driving, by the lift drive, the third conveying component or the first conveying component to move by a distance Y along a vertical direction away from the baking device, to enable the protruding solder strip of the second solar cell to abut against the back side of the non-defective solar cell.

In one or more embodiments, Y0.3 mm.

In one or more embodiments, a distance that the conveying device drives the photovoltaic cell string to move along the first direction is an integer multiple of an orthographic projection of the solar cell along the first direction.

In one or more embodiments, the method for repairing photovoltaic cell string further includes a suction step: when the first conveying component, the second conveying component and the third conveying component drive the first solar cell string, the defective solar cell and the second solar cell string to move, activating negative pressure suction holes on the first conveying component, the second conveying component and the third conveying component and sucking the first solar cell string, the defective solar cell and the second solar cell string thereon.

In one or more embodiments, the method for repairing photovoltaic cell string further includes a compression step: when the protruding solder strip of the non-defective solar cell is located below the baking device, starting a compression device and pushing the protruding solder strip of the non-defective solar cell to be compressed against the back side of the first solar cell; and when the back side of the non-defective solar cell is located below the baking device, starting the compression device and pushing the protruding solder strip of the second solar cell to be compressed against the back side of the non-defective solar cell.

Other features and advantages of the embodiments of the present disclosure will be set forth in part in the specification which follows and in part will become apparent from the specification or may be learned from practice of the embodiments of the present disclosure. The objectives and other advantages of the embodiments of the present disclosure may be realized and attained by the structure particularly pointed out in the specification and the accompanying drawings.

### BRIEF DESCRIPTION OF DRAWINGS

In order to more clearly illustrate the technical solutions in embodiments of the present disclosure, the accompanying drawings used in the description of the embodiments will be briefly introduced below. It is apparent that the accompanying drawings in the following description are only some embodiments of the present disclosure, and other drawings can be obtained by those of ordinary skill in the art from the provided drawings without creative efforts.
FIG. 1 is a schematic structural diagram of a device for repairing photovoltaic cell string according to one or more embodiments of the present disclosure;
FIG. 2 is a schematic structural diagram of a solar cell in a photovoltaic cell string according to one or more embodiments of the present disclosure;
FIG. 3 is a schematic structural diagram of a conveying device of the device for repairing photovoltaic cell string according to one or more embodiments of the present disclosure;
FIG. 4 is a schematic structural diagram of a first conveying component according to one or more embodiments of the present disclosure;
FIG. 5 is a schematic flowchart (I) of a method for repairing photovoltaic cell string according to one or more embodiments of the present disclosure;
FIG. 6 is a schematic flowchart (II) of the method for repairing photovoltaic cell string according to one or more embodiments of the present disclosure;
FIG. 7 is a schematic flowchart (III) of the method for repairing photovoltaic cell string according to one or more embodiments of the present disclosure;
FIG. 8 is a schematic flowchart (IV) of the method for repairing photovoltaic cell string according to one or more embodiments of the present disclosure;
FIG. 9 is a schematic flowchart (V) of the method for repairing photovoltaic cell string according to one or more embodiments of the present disclosure; and
FIG. 10 is a schematic flowchart (VI) of the method for repairing photovoltaic cell string according to one or more embodiments of the present disclosure.

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to better understand the technical solutions of the present disclosure, the following is a detailed description of the embodiments of the present disclosure with reference to the accompanying drawings.

It should be made clear that the embodiments described are only part of rather than all of the embodiments of the present disclosure. All other embodiments acquired by those of ordinary skill in the art without creative efforts based on the embodiments of the present disclosure shall fall within the protection scope of the present disclosure.

The terms used in the specification of the present disclosure are intended only to describe particular embodiments and are not intended to limit the present disclosure. As used in the embodiments of the present disclosure and the appended claims, the singular forms of "a/an", "the", and "said" are intended to include plural forms, unless otherwise clearly specified by the context.

It is to be understood that the term "and/or" used herein is merely an association relationship describing associated objects, indicating that three relationships may exist. For example, A and/or B indicates that there are three cases of A alone, A and B together, and B alone. In addition, the character "/" herein generally means that associated objects before and after "/"are in an "or" relationship.

It is to be noted that orientation words such as "above", "below", "left" and "right" described in the embodiments of the present disclosure are described from the angles as shown in the accompanying drawings and should not be understood as limitations on the embodiments of the present disclosure. In addition, in the context, it is to be further understood that, when one element is connected "above" or "below" another element, it can not only be directly connected "above" or "below" the other element, but also be indirectly connected "above" or "below" the other element through an intermediate element.

Specific embodiments are described below according to a structure of a device for repairing photovoltaic cell string according to the present disclosure.

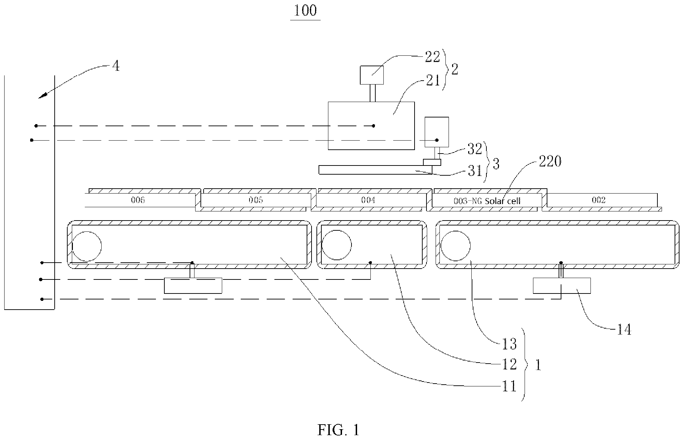

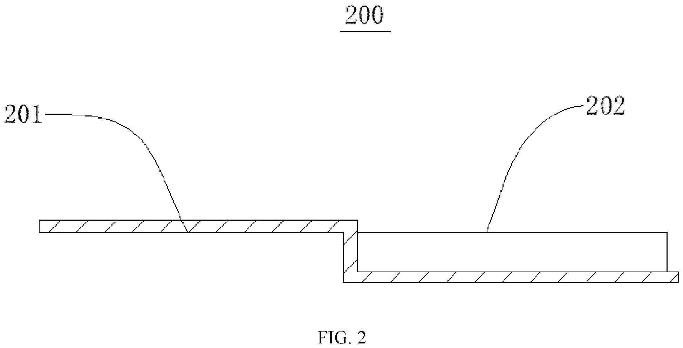

Referring to FIG. 1 and FIG. 2, a photovoltaic cell string is composed of a plurality of solar cells 200. Each solar cell 200 is provided with a solder strip. One part of the solder strip is attached to a front side of the solar cell 200, and the other part of the solder strip protrudes from one side of the solar cell 200. The protruding part is a protruding solder strip 201. The plurality of solar cells 200 are sequentially connected, and the protruding solder strip 201 of each solar cell is connected to a back side 202 of a next solar cell. If a defective solar cell 220 exists in the photovoltaic cell string, the defective solar cell 220 is required to be separated from the photovoltaic cell string through a repair process, and a non-defective solar cell 210 for replacement fills an original position of the defective solar cell 220, so as to ensure the quality of the photovoltaic cell string.

In the related art, the photovoltaic cell string is often repaired manually, the protruding solder strip 201 on the defective solar cell 220 is required to be manually melted, so as to be separated from the photovoltaic cell string. The non-defective solar cell 210 for replacement is then placed at a vacant position on the photovoltaic cell string after the separation of the defective solar cell 220, and the protruding solder strip 201 of the non-defective solar cell 210 abuts against the back side in the photovoltaic cell string. It is to be noted that the "abut against" described in the full text describes that the protruding solder strip 201 and the back side are in an engagement state and are still in a state where they may be separated at any time and not fixedly connected together. Finally, positions of the protruding solder strip 201 and the back side are heated, so that the non-defective solar cell 210 and the photovoltaic cell string are connected to each other.

The repairing manner in the related art has low efficiency, poor accuracy, high costs, low yield, and a low degree of automation. In order to solve the above problems, the present disclosure provides a device for repairing photovoltaic cell string 100.

The device for repairing photovoltaic cell string 100 includes a conveying device 1 and a baking device 2.

The conveying device 1 is configured to drive a photovoltaic cell string placed on the conveying device 1 to reciprocate along a first direction. The conveying device 1 includes a first conveying component 11, a second conveying component 12 and a third conveying component 13 that are separately arranged.

The baking device 2 is arranged toward the second conveying component 12. The baking device 2 is configured to heat the photovoltaic cell string located on the second conveying component 12, so that a protruding solder strip 201 of a solar cell 200 on the photovoltaic cell string is separated or fused at its connecting part. It is to be noted that the connecting part is a back side of next solar cell 200.

Referring to FIG. 1, the conveying device 1 includes a first conveying component 11, a second conveying component 12 and a third conveying component 13 separately arranged. The first conveying component 11, the second conveying component 12 and the third conveying component 13 may be common chain or belt conveyors driven by a motor. The first conveying component 11, the second conveying component 12 and the third conveying component 13 may drive the photovoltaic cell string thereon to reciprocate along a first direction. The first direction may be a horizontal direction. In this way, the photovoltaic cell string placed on the conveying device 1 may move stably along the horizontal direction. The baking device 2 is arranged toward the second conveying component 12. The baking device 2 may include heating wires, a heating lamp tube 221 or any device that may heat the protruding solder strip 201 to a melting temperature. The baking device 2 may heat only the position of the protruding solder strip 201, that is, heat a strip region of the protruding solder strip 201. A heating process of the baking device 2 refers to a soldering process of the protruding solder strip 201. The protruding solder strip 201 is melted by heating, and is fixedly connected to another position after cooling.

The photovoltaic cell string has at least one defective solar cell 220. Taking one defective solar cell 220 as an example, the photovoltaic cell string may be divided into three parts by taking the defective solar cell 220 as a boundary, which are sequentially a first solar cell string 5, the defective solar cell 220 and a second solar cell string 6. The defective solar cell 220 is located between the second solar cell string 6 and the first solar cell string 5. A solar cell in the second solar cell string 6 close to the defective solar cell 220 is a second solar cell 61. A solar cell in the first solar cell string 5 close to one end of the defective solar cell 220 is a first solar cell 51.

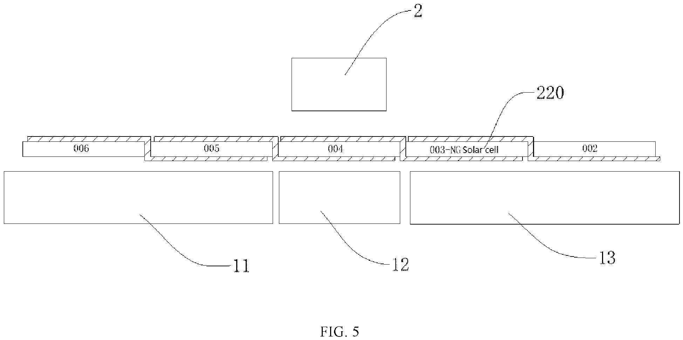

Referring to FIG. 5 to FIG. 10, an embodiment of the device for repairing photovoltaic cell string 100 is provided below, mainly including a desoldering step and a welding step.

The desoldering step includes the following steps.

In a first step, the photovoltaic cell string is placed on the conveying device 1, and the back sides of the solar cells in the photovoltaic cell string are located on one side close to the baking device 2. The conveying device 1 is started and drives the photovoltaic cell string to move along a first direction, until the protruding solder strip 201 of the defective solar cell 220 moves below the baking device 2.

In a second step, the baking device 2 is switched on. In this case, the protruding solder strip 201 of the defective solar cell 220 is located below the baking device 2, the protruding solder strip 201 of the defective solar cell 220 is melted under heat, and a back side of the first solar cell 51 is separated from the protruding solder strip 201 of the defective solar cell 220.

The first conveying component 11 and the second conveying component 12 drive the first solar cell string 5 thereon to move along a direction away from the defective solar cell 220, so that the first solar cell string 5 and the defective solar cell 220 are spaced at a certain distance in the first direction. The spacing distance may be twice the distance of an orthographic projection of the solar cell in the first direction.

In a third step, the third conveying component 13 drives the second solar cell string 6 thereon to move along the first direction until the back side of the defective solar cell 220 moves below the baking device 2. In this case, a body of the defective solar cell 220 is located on the second conveying component 12.

The baking device 2 is switched on. In this case, the back side of the defective solar cell 220 is located below the baking device 2, the protruding solder strip 201 of the second solar cell 61 is melted under heat, and the protruding solder strip 201 of the second solar cell 61 is separated from the back side of the defective solar cell 220.

In a fourth step, the third conveying component 13 drives the second solar cell string 6 thereon to move along a direction away from the defective solar cell 220, so that the second solar cell string 6 and the defective solar cell 220 are spaced at a certain distance in the first direction. It is to be noted that, when the defective solar cell 220 is removed from the device for repairing photovoltaic cell string 100, the protruding solder strip 201 on the second solar cell 61 is removed from above the defective solar cell 220, so that there is no shielding over the defective solar cell 220. Therefore, the defective solar cell 220 may not contact any protruding solder strip 201 when moving up along the vertical direction, so that the defective solar cell 220 may be conveniently removed from the device for repairing photovoltaic cell string 100 manually or by a manipulator.

It is to be noted that a feeding direction of the photovoltaic cell string may move from the first conveying component 11 to the third conveying component 13 or move from the third conveying component 13 to the first conveying component 11. Since the first conveying component 11, the second conveying component 12 and the third conveying component 13 may reciprocate along the first direction, the photovoltaic cell string may be fed from any direction. In this way, adaptability of the device for repairing photovoltaic cell string 100 is improved. The second step and the third step in the desoldering step may be reversed. That is, the back side of the defective solar cell 220 may be desoldered first, and then the protruding solder strip 201 of the defective solar cell 220 is desoldered. The sequence of desoldering of the back side and the protruding solder strip is not limited herein.

The welding step includes the following steps.

In a first step, the first conveying component 11 drives the first solar cell string 5 to move along the first direction, so that the back side of the first solar cell 51 is located below the baking device 2. In this case, the non-defective solar cell 210 is placed on the third conveying component 13, and the protruding solder strip 201 of the non-defective solar cell 210 is attached to the back side of the first solar cell 51.

The baking device 2 is switched on. In this case, the back side of the first solar cell 51 is located below the baking device 2, the protruding solder strip 201 of the non-defective solar cell 210 is melted under heat, and the non-defective solar cell 210 is connected to the first solar cell string 5.

In a second step, the first conveying component 11 and the second conveying component 12 drive the first solar cell string 5 to move toward a direction away from the second solar cell string 6, until the back side of the non-defective solar cell 210 is located below the baking device 2. The third conveying device 13 drives the second solar cell string 6 to move toward a direction close to the non-defective solar cell 210, so that the protruding solder strip 201 of the second solar cell 61 moves below the baking device 2 and is lapped on the back side of the non-defective solar cell 210.

The baking device 2 is switched on. In this case, the back side of the non-defective solar cell 210 is located below the baking device 2, the protruding solder strip 201 of the second solar cell 61 is melted under heat, and the non-defective solar cell 210 is connected to the second solar cell string 6.

So far, the first solar cell string 5, the non-defective solar cell 210 and the second solar cell string 6 are connected into an entirety, and the repair of the photovoltaic cell string is completed.

It is to be noted that the first step and the second step may also be reversed. That is, the back side of the non-defective solar cell 210 may be connected to the protruding solder strip 201 of the second solar cell 61 first, and then the protruding solder strip 201 of the non-defective solar cell 210 is connected to the back side of the first solar cell 51. The sequence of soldering of the back sides is not limited herein.

In one embodiment, the device for repairing photovoltaic cell string 100 further includes a fixing device 3. The fixing device 3 including a press tool 31 and a compression drive 32 connected to each other. The press tool 31 is located between the baking device 2 and the second conveying component 12. The press tool 31 is configured to compress a protruding solder strip 201 abutting between the photovoltaic cell string and the non-defective solar cell 210 for replacement against the back side.

Referring to FIG. 1, the press tool 31 may be a plate-shaped positioning member or any fixture that can ensure a tight contact between the protruding solder strip 201 and the back side. The compression drive 32 may be a device capable of driving the press tool 31 to move, such as a telescopic cylinder. The press tool 31 is located between the baking device 2 and the second conveying component 12. The press tool 31 has at least a compression state and a lifting state. The press tool 31 is driven by the compression drive 32 to switch between the two states. When the baking device 2 is required to start heating, the press tool 31 is in the compression state to ensure that relative positions of the protruding solder strip 201 and the back side may not move when the baking device 2 heats, and the press tool 31 is in the lifting state upon completion of the heating. In this case, the photovoltaic cell string may move freely on the conveying device 1.

With the above configuration, the protruding solder strip 201 and the back side may keep close contact during soldering, which improves the accuracy of soldering.

In one embodiment, the first conveying component 11 and/or the third conveying component 13 are/is provided with a lift drive 14. The lift drive 14 is configured to drive the first conveying component 11 and/or the third conveying component 13 to reciprocate along a vertical direction. The vertical direction is perpendicular to the first direction.

Referring to FIG. 1, the lift drive 14 may be, for example, a telescopic cylinder. The lift drive 14 is connected to the first conveying component 11 and/or the third conveying component 13 to drive the first conveying component 11 and/or the third conveying component 13 to move along the vertical direction perpendicular to the first direction. In this way, the first conveying component 11 and/or the third conveying component 13 may have a height difference in the vertical direction relative to the second conveying component 12, so that the actions in the second step of the welding step may be in a following sequence. The first conveying component 11 and the second conveying component 12 drive the first solar cell string 5 to move toward a direction away from the second solar cell string 6, until the back side of the non-defective solar cell 210 is located below the baking device 2. The lift drive 14 drives the third conveying component 13 up, so that the protruding solder strip 201 of the second solar cell 61 is higher in the vertical direction than the back side of the non-defective solar cell 210. The third conveying component 13 drives the second solar cell string 6 to move toward a direction close to the non-defective solar cell 210, so that the protruding solder strip 201 of the second solar cell 61 moves below the baking device 2 and is located directly above the back side of the non-defective solar cell 210. The lift drive 14 drives the third conveying component 13 down, so that the protruding solder strip 201 of the second solar cell 61 is lapped on the back side of the non-defective solar cell 210. Thus, it is ensured that the protruding solder strip 201 falls naturally during the lapping of the protruding solder strip 201 of the second solar cell 61 with the back side of the non-defective solar cell 210, which prevents deviation and dislocation of the protruding solder strip 201 caused by interference of the protruding solder strip 201 with the body of the non-defective solar cell 210 during parallel movement. It is to be noted that the above action process may also be as follows. The lift drive 14 drives the third conveying component 13 down while the third conveying component 13 drives the second solar cell string 6 to move toward a direction close to the non-defective solar cell 210, so as to save the overall action time and improve operation efficiency. The process described is illustrated with an example in which the photovoltaic cell string moves along a direction from the first conveying component 11 to the third conveying component 13. It may be understood that when the feeding direction of the photovoltaic cell string is reversed, that is, when the photovoltaic cell string moves along a direction from the third conveying component 13 to the first conveying component 11, the lift drive 14 drives the first conveying component 11 to move along the vertical direction. A specific process is not described in detail herein.

Similarly, with the above configuration, the processes in the second step of the desoldering step may also be in a following sequence. The first conveying component 11 and the second conveying component 12 drive the first solar cell string 5 thereon to move along a direction away from the defective solar cell 220. At the same time, the lift drive 14 drives the third conveying component 13 up to drive the protruding solder strip 201 of the defective solar cell 220 to be detached from the first solar cell string 5, or the action that the lift drive 14 drives the third conveying component 13 up to drive the protruding solder strip 201 of the defective solar cell 220 to be detached from the first solar cell string 5 is performed prior to the action that the first conveying component 11 and the second conveying component 12 drive the first solar cell string 5 thereon to move along a direction away from the defective solar cell 220.

In this process, a certain height difference exists between the protruding solder strip 201 of the defective solar cell 220 and the first solar cell string 5, thereby preventing deformation of the protruding solder strip 201 caused by friction or collision between the protruding solder strip 201 of the defective solar cell 220 and the first solar cell string 5.

It may be understood that the actions also apply to the fourth step in the desoldering step. That is, when the third conveying component 13 drives the second solar cell string 6 to move toward a direction away from the defective solar cell 220, the third conveying component 13 may also be driven up by the lift drive 14, so as to prevent friction or collision between the protruding solder strip 201 of the second solar cell 61 and the defective solar cell 220.

In one embodiment, the first conveying component 11 includes a first base plate 111, a first belt 112 arranged around the first base plate 111 and a first drive 113 for driving the first belt 112 to rotate around the first base plate 111; or the second conveying component 12 includes a second base plate 121, a second belt 122 arranged around the second base plate 121 and a second drive 123 for driving the second belt 122 to rotate around the second base plate 121; or the third conveying component 13 includes a third base plate 131, a third belt 132 arranged around the third base plate 131 and a third drive 133 for driving the third belt 132 to rotate around the third base plate 131.

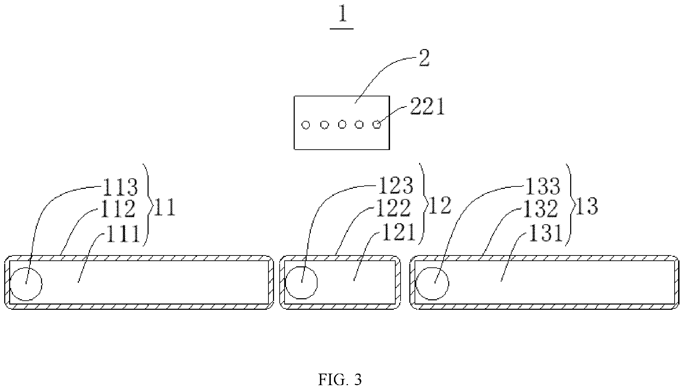

Referring to FIG. 3, according to the above configuration, the base plate, the belt and the drive are combined to form the first conveying component 11, the second conveying component 12 or the third conveying component 13, which has a simple structure, high conveying accuracy, and may reduce maintenance costs and improve productivity.

In one embodiment, at least one of the first base plate 111, the second base plate 121 and the third base plate 131 is provided with a negative pressure suction hole 15. At least one of the first belt 112, the second belt 122 and the third belt 132 is provided with a negative pressure via 16 communicated with the negative pressure suction hole 15. The negative pressure suction hole 15 is communicated with an external negative pressure device, and the negative pressure suction hole 15 is configured to generate negative pressure to suck the photovoltaic cell string on at least one of the first belt 112, the second belt 122 or the third belt 132.

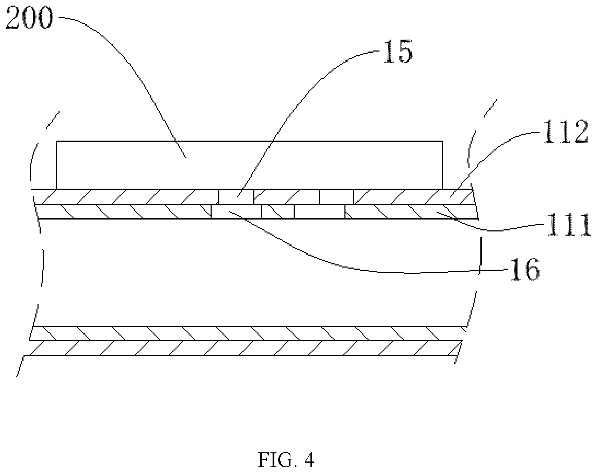

Referring to FIG. 4, taking the first base plate 111 and the first belt 112 as an example, the first base plate 111 is provided with a plurality of negative pressure suction holes 15. The negative pressure suction holes 15 are communicated with an external negative pressure device, so that negative pressure may be formed at the negative pressure suction holes 15. The negative pressure device may be, for example, a common vacuum pump. The first belt 112 is provided with a plurality of negative pressure vias 16. The first belt 112 is wound on the first base plate 111. During the movement of the first belt 112 around the first base plate 111, at least one negative pressure via 16 is always communicated with the negative pressure suction holes 15. The above effect may be achieved by controlling a spacing between the plurality of negative pressure suction holes 15 provided on the first base plate 111 and a spacing between the plurality of negative pressure vias 16 provided on the first belt 112. In addition, the negative pressure vias 16 or the negative pressure suction holes 15 may also be provided as strip holes. In this way, when the first belt 112 moves around the first base plate 111, negative pressure may still be formed at the negative pressure suction holes 15 to suck the photovoltaic cell string on the belt, so as to improve conveying accuracy of the photovoltaic cell string.

In one embodiment, the baking device 2 includes a baking heater 21 and a baking lift 22 connected to each other, and the baking lift 22 is configured to drive the baking heater 21 to move along a vertical direction.

Referring to FIG. 1, the baking heater 21 may be a heating lamp tube 221, and the baking lift 22 may be a telescopic cylinder. The baking lift 22 may adjust a spacing between the baking heater 21 and the second conveying component 12, so as to accurately adjust heat radiated by the baking heater 21 onto the solar cell string, and then accurately control a melting speed of the protruding solder strip 201 on the solar cell string. In this way, in the case of different types of photovoltaic cell strings, the spacing between the baking heater 21 and the second conveying component 12 may be adjusted according to an actual situation, so as to control the melting speed of the protruding solder strip 201. In addition, at the end of the baking, the baking lift 22 may lift the baking heater 21 to increase the spacing between it and the second conveying component 12, which plays a role of avoidance and facilitates the conveying device 1 to transport the photovoltaic cell string along the first direction.

In one embodiment, the baking heater 21 includes a plurality of lamp tubes 221 separately arranged, and the plurality of lamp tubes 221 are spaced along the first direction.

The plurality of lamp tubes 221 may ensure more uniform heat radiation. Moreover, the plurality of lamp tubes 221 may be provided adapt to photovoltaic cell strings of different types and sizes. When the solar cells in the photovoltaic cell string are wider, the plurality of lamp tubes 221 are turned on according to sizes of orthographic projections of the solar cells on the baking device 2. It may be understood that, when the solar cells in the photovoltaic cell string are narrower, the number of lamp tubes 221 turned on may be reduced. In this way, energy is saved, and the adaptability of the device for repairing photovoltaic cell string 100 is improved.

In one embodiment, the device for repairing photovoltaic cell string 100 further includes a control device 4. The control device 4 is electrically connected to the conveying device 1 and the baking device 2, the control device 4 is configured to control a conveying stroke and a conveying direction of the conveying device 1, and the control device 4 is further configured to control ON and OFF of the baking device 2.

Referring to FIG. 1, the control device 4 may be a common programmable logic controller (PLC), a single-chip microcomputer controller or a computer device. The control device 4 controls a conveying stroke and a conveying direction of the conveying device 1 according to an actual situation, and further controls ON and OFF and other parameters of the baking device 2, to realize intelligence and automation.

In one embodiment, a length of the conveying stroke is an integer multiple of a length of an orthographic projection of a single solar cell in the photovoltaic cell string in the first direction.

A unit conveying distance at which the conveying device 1 transports the photovoltaic cell string is an integer multiple of a length of an orthographic projection of a single solar cell in the first direction. If the length of the orthographic projection of the single solar cell in the first direction is at a distance of X, distances at which the first conveying component 11, the second conveying component 12 and the third conveying component 13 in the conveying device 1 transport the photovoltaic cell string (including the first solar cell string 5 and the second solar cell string 6 formed by decomposition of the photovoltaic cell string) thereon at a time are an integer multiple of X. In this way, the conveying accuracy is improved, so that the protruding solder strip 201 on the photovoltaic cell string may be accurately lapped on the back side.

Referring to FIG. 5 to FIG. 10, in one embodiment, the method for repairing photovoltaic cell string includes the following steps.

In a feeding step, the photovoltaic cell string is placed on a conveying device 1, and the back sides of the solar cells in the photovoltaic cell string are located on one side close to the baking device 2. The plurality of solar cells include at least one defective solar cell 220. The conveying device 1 includes a first conveying component 11, a second conveying component 12 and a third conveying component 13 that are arranged separately and capable of driving the photovoltaic cell string to reciprocate along a first direction. The baking device 2 is arranged above the second conveying component 12.

In a desoldering step, the conveying device 1 drives the photovoltaic cell string to move along the first direction to enable a protruding solder strip 201 and a back side of the defective solar cell 220 to be located below the baking device 2. The baking device 2 heats to enable the protruding solder strip on the photovoltaic cell string to be separated from its connecting part and the photovoltaic cell string to be decomposed into a first solar cell string 5, the defective solar cell 220 and a second solar cell string 6.

In a welding step, the conveying device 1 drives the first solar cell string 5 and the second solar cell string 6 to move, a non-defective solar cell 210 for replacement is placed on the conveying device 1, so that the non-defective solar cell 210 abuts against the first solar cell string 5 and the second solar cell string 6, and the conveying device 1 drives a protruding solder strip 201 and the back side of the non-defective solar cell 210 to be located below the baking device 2. The baking device 2 heats to enable the first solar cell string 5, the non-defective solar cell 210 and the second solar cell string 6 to be connected.

In one embodiment, a solar cell in the second solar cell string 6 connected to the defective solar cell 220 is a second solar cell 61, and a solar cell in the first solar cell string 5 connected to the defective solar cell 220 is a first solar cell 51. The desoldering step further includes:, driving, by the conveying device 1, the photovoltaic cell string to move along the first direction, locating the protruding solder strip 201 of the defective solar cell 220 in a baking station between the baking device 2 and the second conveying component 12, the baking device 2 heating to enable the protruding solder strip to be separated from its connecting part and the defective solar cell 220 to be separated from the first solar cell 51.

The conveying device 1 drives the second solar cell string 6 to move along the first direction, and the back side of the defective solar cell 220 is located in the baking station, the baking device 2 heats to enable the defective solar cell 220 to be separated from the second solar cell 61, and the third conveying component 13 drives the second solar cell string 6 to move along a direction away from the defective solar cell 220, to detach a protruding solder strip 201 of the second solar cell 61 from the back side of the defective solar cell 220.

In one embodiment, the welding step further includes: driving, by the first conveying component 11, the first solar cell string 5 to move, so that the first solar cell 51 is located at the baking station, placing the non-defective solar cell 210 and enabling the protruding solder strip 201 thereof to abut against a back side of the first solar cell 51, and the baking device 2 heating to enable the non-defective solar cell 210 to be connected the first solar cell string 5; and driving, by the first conveying component 11, the first solar cell string 5 to move, so that the back side of the non-defective solar cell 210 is located at the baking station, and driving, by the third conveying component 13, the second solar cell string 6 to move in the first direction, so that the protruding solder strip 201 of the second solar cell 61 abuts against the back side of the non-defective solar cell 210, and the baking device 2 heating to enable the non-defective solar cell 210 to be connected to the second solar cell string 6.

Embodiment 1 of the method for repairing photovoltaic cell string is provided below.

The feeding step includes the following steps.

Referring to FIG. 5, the photovoltaic cell string is placed on the conveying device 1, and the back sides of the solar cells in the photovoltaic cell string are located on one side close to the baking device 2. The plurality of solar cells include at least one defective solar cell 220. The conveying device 1 includes a first conveying component 11, a second conveying component 12 and a third conveying component 13 that are arranged separately and capable of driving the photovoltaic cell string to reciprocate along a first direction. The baking device 2 is arranged above the second conveying component 12.

The desoldering step includes the following steps.

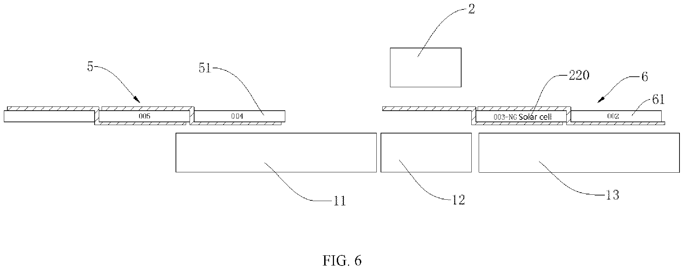

Referring to FIG. 6, the photovoltaic cell string is placed on the conveying device 1, and the back sides of the solar cells in the photovoltaic cell string are located on one side close to the baking device 2. The conveying device 1 is started and drives the photovoltaic cell string to move along a first direction, until the protruding solder strip 201 of the defective solar cell 220 moves below the baking device 2. The baking device 2 is switched on. In this case, the protruding solder strip 201 of the defective solar cell 220 is located below the baking device 2, the protruding solder strip 201 of the defective solar cell 220 is melted under heat, and a back side of the first solar cell 51 is separated from the protruding solder strip 201 of the defective solar cell 220.

The first conveying component 11 and the second conveying component 12 drive the first solar cell string 5 thereon to move along a direction away from the defective solar cell 220, so that the first solar cell string 5 and the defective solar cell 220 are spaced at a certain distance in the first direction. The spacing distance may be twice a distance of an orthographic projection of the solar cell in the first direction. The third conveying component 13 drives the second solar cell string 6 thereon to move along the first direction until the back side of the defective solar cell 220 moves below the baking device 2. In this case, a body of the defective solar cell 220 is located on the second conveying component 12.

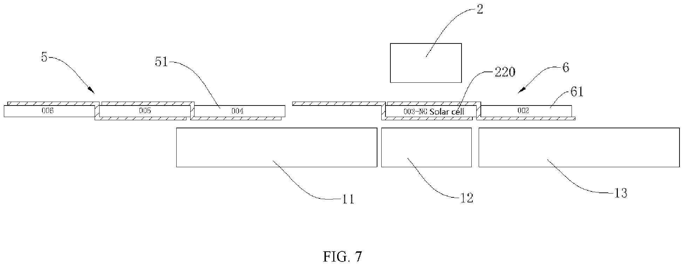

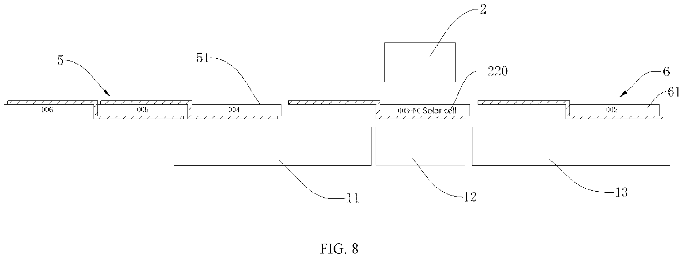

Referring to FIG. 7 and FIG. 8, the baking device 2 is switched on. In this case, the back side of the defective solar cell 220 is located below the baking device 2, the protruding solder strip 201 of the second solar cell 61 is melted under heat, and the protruding solder strip 201 of the second solar cell 61 is separated from the back side of the defective solar cell 220.

The third conveying component 13 drives the second solar cell string 6 thereon to move along a direction away from the defective solar cell 220, so that the second solar cell string 6 and the defective solar cell 220 are spaced at a certain distance in the first direction, so as to make it easy to remove the defective solar cell 220 from the device for repairing photovoltaic cell string 100 manually or by a manipulator.

The welding step includes the following steps.

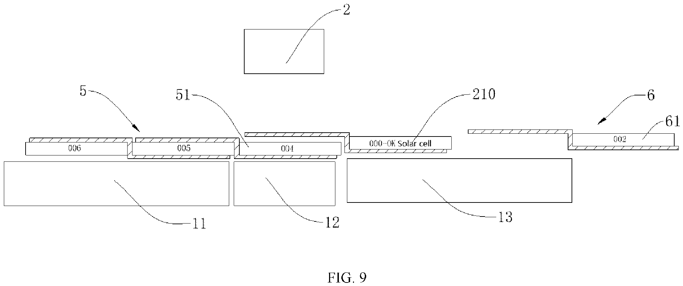

Referring to FIG. 9, the first conveying component 11 drives the first solar cell string 5 to move along the first direction, so that the back side of the first solar cell 51 is located below the baking device 2. In this case, the non-defective solar cell 210 is placed on the third conveying component 13, and the protruding solder strip 201 of the non-defective solar cell 210 is attached to the back side of the first solar cell 51.

The baking device 2 is switched on. In this case, the back side of the first solar cell 51 is located below the baking device 2, the protruding solder strip 201 of the non-defective solar cell 210 is melted under heat, and the non-defective solar cell 210 is connected to the first solar cell string 5.

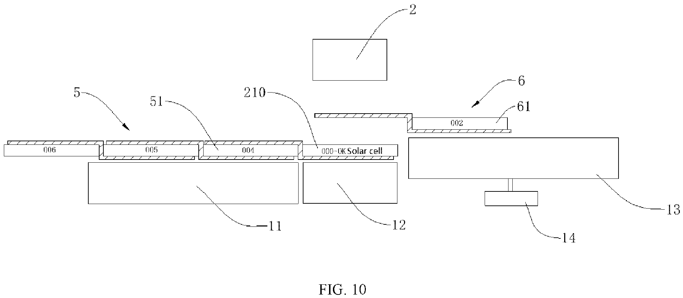

Referring to FIG. 10, the first conveying component 11 and the second conveying component 12 drive the first solar cell string 5 to move toward a direction away from the second solar cell string 6, until the back side of the non-defective solar cell 210 is located below the baking device 2. The third conveying device 13 drives the second solar cell string 6 to move toward a direction close to the non-defective solar cell 210, so that the protruding solder strip 201 of the second solar cell 61 moves below the baking device 2 and is lapped on the back side of the non-defective solar cell 210.

The baking device 2 is switched on. In this case, the back side of the non-defective solar cell 210 is located below the baking device 2, the protruding solder strip 201 of the second solar cell 61 is melted under heat, and the non-defective solar cell 210 is connected to the second solar cell string 6.

So far, the first solar cell string 5, the non-defective solar cell 210 and the second solar cell string 6 are connected into an entirety, and the repair of the photovoltaic cell string is completed.

In one embodiment, the method for repairing photovoltaic cell string further includes the following steps.

In a combining step, the lift drive 14 is connected to the third conveying component 13, the lift drive 14 is configured to drive the third conveying component 13 to move along a vertical direction, and after the first conveying component 11 drives the first solar cell string 5 to move to enable the non-defective solar cell 210 for replacement to be located at the baking station, the lift drive 14 drives the third conveying component 13 to move by a distance Y along a vertical direction close to the baking device 2.

The third conveying component 13 drives the second solar cell string 6 to move along the first direction close to the first solar cell string 5, until the protruding solder strip 201 of the second solar cell 61 is located above the non-defective solar cell 210, and the lift drive 14 drives the third conveying component 13 to move by a distance Y along a vertical direction away from the baking device 2, to enable the protruding solder strip 201 of the second solar cell 61 to abut against the back side of the non-defective solar cell 210.

It is to be noted that, when the feeding direction of the photovoltaic cell string moves from the third conveying component 13 to the first conveying component 11, the lift drive 14 is connected to the first conveying component 11, the lift drive 14 is configured to drive the first conveying component 11 to move along a vertical direction, and after the third conveying component 13 drives the first solar cell string 5 to move to enable the non-defective solar cell 210 for replacement to be located at the baking station, the lift drive 14 drives the first conveying component 11 to move by a distance Y along a vertical direction close to the baking device 2.

Embodiment 2 of the method for repairing photovoltaic cell string is provided below.

Referring to FIG. 1 and FIG. 10, compared with Embodiment 1, a combining step is added to the method for repairing photovoltaic cell string according to Embodiment 2, and the remaining steps are the same except the following differences. In the welding step, when the back side of the non-defective solar cell 210 is located below the baking device 2, instead of directly driving, by the third conveying component 13, the second solar cell string 6 to move toward a direction close to the non-defective solar cell 210, a step of driving, by the lift drive 14, the third conveying component 13 up is added prior to the step of driving, by the third conveying component 13, the second solar cell string 6 to move toward a direction close to the non-defective solar cell 210. This process causes a height difference Y between the second solar cell string 6 and the non-defective solar cell 210. The difference is greater than a sum of a thickness of the non-defective solar cell 210 and a thickness of the protruding solder strip 201. In one embodiment, Y≥0.3 mm. Afterwards or at the same time, the third conveying component 13 drives the second solar cell string 6 to move toward a direction close to the non-defective solar cell 210. Finally, the lift drive 14 drives the third conveying component 13 down, so that the protruding solder strip 201 of the second solar cell 61 moves below the baking device 2 and is lapped on the back side of the non-defective solar cell 210.

Through performing the above combining step, an interference risk during the lapping of the protruding solder strip 201 on the solar cell on the back side of the solar cell is reduced, and accuracy and success probability of connecting the second solar cell string 6 to the non-defective solar cell 210 are improved.

In one embodiment, the distance that the conveying device 1 drives the photovoltaic cell string to move along the first direction is an integer multiple of an orthographic projection of the solar cell in the first direction. It may be understood that, for the same purpose, if the length of the projection of the single solar cell in the first direction is at a distance of X, distances at which the first conveying component 11, the second conveying component 12 and the third conveying component 13 in the conveying device 1 transport the photovoltaic cell string (including the first solar cell string 5 and the second solar cell string 6 formed by decomposition of the photovoltaic cell string) thereon at a time are an integer multiple of X. In this way, the conveying accuracy is improved, so that the protruding solder strip 201 on the photovoltaic cell string may be accurately separated from and lapped on the back side.

In one embodiment, a suction step is added to the method for repairing photovoltaic cell string. When the first conveying component 11, the second conveying component 12 and the third conveying component 13 drive the first solar cell string 5, the defective solar cell 220 and the second solar cell string 6 to move, negative pressure suction holes 15 on the first conveying component 11, the second conveying component 12 and the third conveying component 13 are opened, and the first solar cell string 5, the defective solar cell 220 and the second solar cell string 6 are sucked thereon.

It may be understood that the first conveying component 11, the second conveying component 12 and the third conveying component 13 may be provided with the negative pressure suction holes 15 communicated with an external negative pressure device, so as to achieve the purpose that the first conveying component 11, the second conveying component 12 and the third conveying component 13 suck the first solar cell string 5, the defective solar cell 220 and the second solar cell string 6 thereon, thereby improving the conveying accuracy of the photovoltaic cell string.

In one embodiment, a compression step is added to the method for repairing photovoltaic cell string. When the protruding solder strip 201 of the non-defective solar cell 210 is located below the baking device 2, a compression device is started and pushes the protruding solder strip 201 of the non-defective solar cell 210 to be compressed against the back side of the first solar cell 51.

When the back side of the non-defective solar cell 210 is located below the baking device 2, the compression device is started and pushes the protruding solder strip 201 of the second solar cell 61 to be compressed against the back side of the non-defective solar cell 210.

It may be understood that the compression device may be the fixing device 3 described above or a common lever clamping cylinder configured to fix a workpiece. The fixing device 3 including a press tool 31 and a compression drive 32 connected to each other. The press tool 31 is located between the baking device 2 and the second conveying component 12. The press tool 31 is configured to compress a protruding solder strip 201 abutting between the photovoltaic cell string and the non-defective solar cell 210 for replacement against a back side. With the above configuration, the protruding solder strip 201 and the back side may keep close contact during soldering, which improves the accuracy of soldering.

To sum up, the method for repairing photovoltaic cell string according to the present disclosure can solve the problems of low efficiency and low yield of a repair process of photovoltaic cell strings in the related art.

The above are only preferred embodiments of the present disclosure and are not intended to limit the present disclosure. Any modifications, equivalent substitutions, improvements and the like made within the principle of the present disclosure should fall within the protection scope of the present disclosure.

## Claims

1. A device for repairing photovoltaic cell string, **characterized by** comprising:
a conveying device (1) configured to drive a photovoltaic cell string (100) placed on the conveying device to reciprocate along a first direction, wherein the conveying device comprises a first conveying component (11), a second conveying component (12) and a third conveying component (13) that are separately arranged; and
a baking device (2) arranged toward the second conveying component (12),
wherein the photovoltaic cell string (100) comprises a plurality of solar cells (200), adjacent solar cells of the plurality of solar cells (200) are connected by a solder strip, the plurality of solar cells comprise a first solar cell (51), a second solar cell (61) and a defective solar cell (220) between the first solar cell (51) and the second solar cell (61), a back side (202) of the first solar cell (51) is attached to a protruding solder strip (201) of a first solder strip, the other part of the first solder strip is attached to a front side of the defective solar cell (220), a back side (202) of the defective solar cell (220) is attached to a protruding solder strip (201) of a second solder strip, and the other part of the second solder strip is attached to a front side of the second solar cell (61),
wherein the conveying device (1) moves the first solar cell (51) onto the second conveying component (12), the baking device (2) heats the first solar cell (51) and the protruding solder strip (201) of the first solder strip so as to separate the first solar cell (51) and the defective solar cell (220), the conveying device (1) moves the defective solar cell (220) onto the second conveying component (12), the baking device (2) heats the defective solar cell (220) and the protruding solder strip (201) of the second solder strip so as to separate the defective solar cell (220) and the second solar cell, the conveying device (1) moves the first solar cell (51) onto the second conveying component (12), the baking device (2) heats the first solar cell (51) and a protruding solder strip (201) of another solder strip, the other part of the another solder strip being attached to a front side of an replacement solar cell, so that the first solar cell (51) is connected to the replacement solar cell, the conveying device (1) moves the replacement solar cell onto the second conveying component (12), the baking device (2) heats the replacement solar cell and the protruding solder strip (201) of the second solder strip, so that the replacement solar cell is connected to the second solar cell (61).

2. The device for repairing photovoltaic cell string according to claim 1, **characterized by** further comprising a fixing device (3), wherein the fixing device (3) comprises a press tool (31) and a compression drive (32) connected to each other, the press tool (31) is located between the baking device (2) and the second conveying component (12), and the press tool (31) is configured to compress the photovoltaic cell string against the replacement solar cell at a position of the protruding solder strip and the corresponding back side.

3. The device for repairing photovoltaic cell string according to claim 1, **characterized in that**, the first conveying component (11) and/or the third conveying component (13) is provided with a lift drive (14), the lift drive (14) is configured to drive the first conveying component (11) and/or the third conveying component (13) to reciprocate along a vertical direction, and the vertical direction is perpendicular to the first direction.

4. The device for repairing photovoltaic cell string according to claim 1, **characterized in that**, the first conveying component (11) comprises a first base plate (111), a first belt (112) arranged around the first base plate, and a first drive (113) for driving the first belt (112) to rotate around the first base plate; or
the second conveying component (12) comprises a second base plate (121), a second belt (122) arranged around the second base plate (121), and a second drive (123) for driving the second belt to rotate around the second base plate; or
the third conveying component (13) comprises a third base plate (131), a third belt (132) arranged around the third base plate (131), and a third drive (133) for driving the third belt to rotate around the third base plate.

5. The device for repairing photovoltaic cell string according to claim 4, **characterized in that**, at least one of the first base plate (111), the second base plate (121) or the third base plate (131) is provided with a negative pressure suction hole (15), at least one of the first belt (111), the second belt (121) or the third belt (131) is provided with a negative pressure via (16) communicated with the negative pressure suction hole (15), the negative pressure suction hole (15) is communicated with an external negative pressure device, and the negative pressure suction hole (15) is configured to generate negative pressure to suck the photovoltaic cell string (100) on at least one of the first belt, the second belt or the third belt.

6. The device for repairing photovoltaic cell string according to claim 1, **characterized in that**, the baking device (2) comprises a baking heater (21) and a baking lift (22) connected to each other, the baking lift (22) is configured to drive the baking heater (21) to move along a vertical direction.

7. The device for repairing photovoltaic cell string according to claim 6, **characterized in that**, the baking heater (21) comprises a plurality of lamp tubes (221) separately arranged and spaced along the first direction.

8. The device for repairing photovoltaic cell string according to claim 1, **characterized by** further comprising a control device (4) electrically connected to the conveying device (1) and the baking device (2), wherein the control device (4) is configured to control a conveying stroke and a conveying direction of the conveying device, and is further configured to control ON and OFF of the baking device (2).

9. A method for repairing a photovoltaic cell string, **characterized by** comprising:
a feeding step: the photovoltaic cell string including a plurality of solar cells (200), adjacent solar cells of the plurality of solar cells (200) being connected by a solder strip, placing the photovoltaic cell string on a conveying device (1), and locating the back sides of the plurality of solar cells (200) in the photovoltaic cell string on one side close to a baking device (2), wherein the plurality of solar cells (200) comprise a first solar cell (51), a second solar cell (61), and a defective solar cell (220) between the first solar cell (51) and the second solar cell (61), the back side (202) of the first solar cell (51) is attached to a protruding solder strip (201) of a first solder strip, the other part of the first solder strip is attached to a front side of the defective solar cell (220), the back side (202) of the defective solar cell (220) is attached to a protruding solder strip (201) of a second solder strip, and the other part of the second solder strip is attached to a front side of the second solar cell (61), the conveying device (1) comprises a first conveying component (11), a second conveying component (12) and a third conveying component (13) that are arranged separately and capable of driving the photovoltaic cell string to reciprocate along a first direction, and the baking device (2) is arranged above the second conveying component (12);
a desoldering step: driving, by the conveying device (1), the photovoltaic cell string to move along the first direction to enable the protruding solder strip (201) of the first solder strip and the back side (202) of the first solar cell (51) to be located below the baking device (2), and heating by the baking device (2) so that the defective solar cell (220) is disconnected from the first solar cell (51), and driving, by the conveying device (1), the photovoltaic cell string to move along the first direction to enable the protruding solder strip (201) of the second solder strip and the back side (202) of the defective solar cell (220) to be located below the baking device (2), and heating by the baking device (2), so that the defective solar cell (220) is disconnected from the second solar cell (61) and the photovoltaic cell string is decomposed into a first solar cell string (5) including the first solar cell (51), the defective solar cell (220) and a second solar cell string (6) including the second solar cell (61); and
a welding step: driving, by the conveying device (1), the first solar cell string (5) and the second solar cell string (6) to move, placing a replacement solar cell on the conveying device (1), so that the replacement solar cell abuts against the first solar cell string (5) and the second solar cell string (6), driving, by the conveying device (1), a protruding solder strip (201) of another solder strip connected to the replacement solar cell and the back side of the first solar cell (51) to be located below the baking device (2), and heating by the baking device (2) to enable the replacement solar cell and the first solar cell string (5) to be connected, driving, by the first conveying component (11), the first solar cell string (5) to move, so that the back side of the replacement solar cell is located below the baking device (2), driving, by the third conveying component (13), the second solar cell string to move in the first direction, so that the protruding solder strip of the second solder strip is located below the baking device (2) and abuts against the back side of the replacement solar cell, and heating by the baking device (2) to enable the replacement solar cell and the second solar cell string (6) to be connected.

10. The method for repairing photovoltaic cell string according to claim 9, **characterized by** further comprising:
a combining step: after the first conveying component (11) drives the first solar cell string to move to enable the replacement solar cell to be located below the baking device (2), driving, by the lift drive, the third conveying component (13) to move by a distance Y along a vertical direction close to the baking device; and
driving, by the third conveying component (13), the second solar cell string (6) to move along the first direction close to the first solar cell string (5), until the protruding solder strip of the second solder strip is located above the replacement solar cell, and driving, by the lift drive, the third conveying component (13) to move by a distance Y along a vertical direction away from the baking device, to enable the protruding solder strip of the second solder strip to abut against the back side of the replacement solar cell.

11. The method for repairing photovoltaic cell string according to claim 10, **characterized in that**, Y≥0.3 mm.

12. The method for repairing photovoltaic cell string according to claim 9, **characterized in that**, a distance that the conveying device drives the photovoltaic cell string to move along the first direction is an integer multiple of an orthographic projection of the solar cell along the first direction.

13. The method for repairing photovoltaic cell string according to claim 9, **characterized by** further comprising:
a suction step: when the first conveying component (11), the second conveying component (12) and the third conveying component (13) drive the first solar cell string (5), the defective solar cell (220) and the second solar cell string (6) to move, activating negative pressure suction holes on the first conveying component (11), the second conveying component (12) and the third conveying component (13) and sucking the first solar cell string (5), the defective solar cell (220) and the second solar cell string (6) thereon.

14. The method for repairing photovoltaic cell string according to claim 9, **characterized by** further comprising:
a compression step: when the protruding solder strip of another solder strip connected to the replacement solar cell is located below the baking device (2), starting a compression device and pushing the protruding solder strip of another solder strip connected to the replacement solar cell to be compressed against the back side of the first solar cell (51); and
when the back side of the replacement solar cell is located below the baking device (2), starting the compression device and pushing the protruding solder strip of the second solder strip to be compressed against the back side of the replacement solar cell.

## Patentansprüche

1. Vorrichtung zur Reparatur eines Solarzellenstranges, **dadurch gekennzeichnet, dass** sie umfasst:
eine Fördervorrichtung (1), die dafür ausgelegt ist, einen auf der Fördervorrichtung angeordneten Solarzellenstrang (100) in eine hin- und hergehende Bewegung entlang einer ersten Richtung zu versetzen, wobei die Fördervorrichtung eine erste Förderkomponente (11), eine zweite Förderkomponente (12) und eine dritte Förderkomponente (13) umfasst, welche getrennt angeordnet sind; und
eine Erhitzungsvorrichtung (2), die gegenüber der zweiten Förderkomponente (12) angeordnet ist,
wobei der Solarzellenstrang (100) mehrere Solarzellen (200) umfasst, benachbarte Solarzellen der mehreren Solarzellen (200) durch einen Lötstreifen verbunden sind, die mehreren Solarzellen eine erste Solarzelle (51), eine zweite Solarzelle (61) und eine defekte Solarzelle (220) zwischen der ersten Solarzelle (51) und der zweiten Solarzelle (61) umfassen, eine Rückseite (202) der ersten Solarzelle (51) an einem vorstehenden Lötstreifen (201) eines ersten Lötstreifens befestigt ist, der andere Teil des ersten Lötstreifens an einer Vorderseite der defekten Solarzelle (220) befestigt ist, eine Rückseite (202) der defekten Solarzelle (220) an einem vorstehenden Lötstreifen (201) eines zweiten Lötstreifens befestigt ist und der andere Teil des zweiten Lötstreifens an einer Vorderseite der zweiten Solarzelle (61) befestigt ist,
wobei die Fördervorrichtung (1) die erste Solarzelle (51) auf die zweite Förderkomponente (12) bewegt, die Erhitzungsvorrichtung (2) die erste Solarzelle (51) und den vorstehenden Lötstreifen (201) des ersten Lötstreifens erhitzt, um so die erste Solarzelle (51) und die defekte Solarzelle (220) zu trennen, die Fördervorrichtung (1) die defekte Solarzelle (220) auf die zweite Förderkomponente (12) bewegt, die Erhitzungsvorrichtung (2) die defekte Solarzelle (220) und den vorstehenden Lötstreifen (201) des zweiten Lötstreifens erhitzt, um so die defekte Solarzelle (220) und die zweite Solarzelle zu trennen, die Fördervorrichtung (1) die erste Solarzelle (51) auf die zweite Förderkomponente (12) bewegt, die Erhitzungsvorrichtung (2) die erste Solarzelle (51) und einen vorstehenden Lötstreifen (201) eines anderen Lötstreifens erhitzt, wobei der andere Teil des anderen Lötstreifens an einer Vorderseite einer Ersatz-Solarzelle befestigt ist, so dass die erste Solarzelle (51) mit der Ersatz-Solarzelle verbunden wird, die Fördervorrichtung (1) die Ersatz-Solarzelle auf die zweite Förderkomponente (12) bewegt, die Erhitzungsvorrichtung (2) die Ersatz-Solarzelle und den vorstehenden Lötstreifen (201) des zweiten Lötstreifens erhitzt, so dass die Ersatz-Solarzelle mit der zweiten Solarzelle (61) verbunden wird.

2. Vorrichtung zur Reparatur eines Solarzellenstranges nach Anspruch 1, **dadurch gekennzeichnet, dass** sie ferner eine Befestigungsvorrichtung (3) umfasst, wobei die Befestigungsvorrichtung (3) ein Presswerkzeug (31) und einen Drückantrieb (32), die miteinander verbunden sind, umfasst, das Presswerkzeug (31) zwischen der Erhitzungsvorrichtung (2) und der zweiten Förderkomponente (12) angeordnet ist und das Presswerkzeug (31) dafür ausgelegt ist, den Solarzellenstrang gegen die Ersatz-Solarzelle an einer Position des vorstehenden Lötstreifens und der entsprechenden Rückseite zu drücken.

3. Vorrichtung zur Reparatur eines Solarzellenstranges nach Anspruch 1, **dadurch gekennzeichnet, dass** die erste Förderkomponente (11) und/oder die dritte Förderkomponente (13) mit einem Hubantrieb (14) versehen sind, der Hubantrieb (14) dafür ausgelegt ist, die erste Förderkomponente (11) und/oder die dritte Förderkomponente (13) in eine hin- und hergehende Bewegung entlang einer vertikalen Richtung zu versetzen und die vertikale Richtung senkrecht zur ersten Richtung ist.

4. Vorrichtung zur Reparatur eines Solarzellenstranges nach Anspruch 1, **dadurch gekennzeichnet, dass** die erste Förderkomponente (11) eine erste Grundplatte (111), einen ersten Gurt (112), der um die erste Grundplatte herum angeordnet ist, und einen ersten Antrieb (113) zum Antreiben des ersten Gurtes (112) zur Rotation um die erste Grundplatte umfasst; oder
die zweite Förderkomponente (12) eine zweite Grundplatte (121), einen zweiten Gurt (122), der um die zweite Grundplatte (121) herum angeordnet ist, und einen zweiten Antrieb (123) zum Antreiben des zweiten Gurtes zur Rotation um die zweite Grundplatte umfasst; oder
die dritte Förderkomponente (13) eine dritte Grundplatte (131), einen dritten Gurt (132), der um die dritte Grundplatte (131) herum angeordnet ist, und einen dritten Antrieb (133) zum Antreiben des dritten Gurtes zur Rotation um die dritte Grundplatte umfasst.

5. Vorrichtung zur Reparatur eines Solarzellenstranges nach Anspruch 4, **dadurch gekennzeichnet, dass** wenigstens eine von der ersten Grundplatte (111), der zweiten Grundplatte (121) und der dritten Grundplatte (131) mit einem Unterdruck-Saugloch (15) versehen ist, wenigstens einer von dem ersten Gurt (111), dem zweiten Gurt (121) und dem dritten Gurt (131) mit einem Unterdruck-Durchgangsloch (16) versehen ist, das mit dem Unterdruck-Saugloch (15) in Verbindung steht, das Unterdruck-Saugloch (15) mit einer externen Unterdruckvorrichtung in Verbindung steht und das Unterdruck-Saugloch (15) dafür ausgelegt ist, einen Unterdruck zu erzeugen, um den Solarzellenstrang (100) an wenigstens einen von dem ersten Gurt, dem zweiten Gurt und dem dritten Gurt anzusaugen.

6. Vorrichtung zur Reparatur eines Solarzellenstranges nach Anspruch 1, **dadurch gekennzeichnet, dass** die Erhitzungsvorrichtung (2) einen Erhitzer (21) und eine Erhitzungs-Hebevorrichtung (22), die miteinander verbunden sind, umfasst, wobei die Erhitzungs-Hebevorrichtung (22) dafür ausgelegt ist, den Erhitzer (21) in eine Bewegung entlang einer vertikalen Richtung zu versetzen.

7. Vorrichtung zur Reparatur eines Solarzellenstranges nach Anspruch 6, **dadurch gekennzeichnet, dass** der Erhitzer (21) mehrere Lampenröhren (221) umfasst, die getrennt angeordnet und entlang der ersten Richtung beabstandet sind.

8. Vorrichtung zur Reparatur eines Solarzellenstranges nach Anspruch 1, **dadurch gekennzeichnet, dass** sie ferner eine Steuervorrichtung (4) umfasst, die mit der Fördervorrichtung (1) und der Erhitzungsvorrichtung (2) elektrisch verbunden ist, wobei die Steuervorrichtung (4) dafür ausgelegt ist, einen Förderhub und eine Förderrichtung der Fördervorrichtung zu steuern, und ferner dafür ausgelegt ist, das Ein- und Ausschalten der Erhitzungsvorrichtung (2) zu steuern.

9. Verfahren zur Reparatur eines Solarzellenstranges, **dadurch gekennzeichnet, dass** es umfasst:
einen Zuführschritt: wobei der Solarzellenstrang mehrere Solarzellen (200) umfasst, wobei benachbarte Solarzellen der mehreren Solarzellen (200) durch einen Lötstreifen verbunden sind; Anordnen des Solarzellenstranges auf einer Fördervorrichtung (1) und Positionieren der Rückseiten der mehreren Solarzellen (200) in dem Solarzellenstrang auf einer Seite nahe an einer Erhitzungsvorrichtung (2), wobei die mehreren Solarzellen (200) eine erste Solarzelle (51), eine zweite Solarzelle (61) und eine defekte Solarzelle (220) zwischen der ersten Solarzelle (51) und der zweiten Solarzelle (61) umfassen, die Rückseite (202) der ersten Solarzelle (51) an einem vorstehenden Lötstreifen (201) eines ersten Lötstreifens befestigt ist, der andere Teil des ersten Lötstreifens an einer Vorderseite der defekten Solarzelle (220) befestigt ist, die Rückseite (202) der defekten Solarzelle (220) an einem vorstehenden Lötstreifen (201) eines zweiten Lötstreifens befestigt ist und der andere Teil des zweiten Lötstreifens an einer Vorderseite der zweiten Solarzelle (61) befestigt ist, die Fördervorrichtung (1) eine erste Förderkomponente (11), eine zweite Förderkomponente (12) und eine dritte Förderkomponente (13) umfasst, welche getrennt angeordnet sind und in der Lage sind, den Solarzellenstrang in eine hin- und hergehende Bewegung entlang einer ersten Richtung zu versetzen, und die Erhitzungsvorrichtung (2) über der zweiten Förderkomponente (12) angeordnet ist;
einen Entlötschritt: Versetzen, durch die Fördervorrichtung (1), des Solarzellenstranges in eine Bewegung entlang der ersten Richtung, um zu ermöglichen, dass der vorstehende Lötstreifen (201) des ersten Lötstreifens und die Rückseite (202) der ersten Solarzelle (51) unter der Erhitzungsvorrichtung (2) positioniert werden, und Erhitzen durch die Erhitzungsvorrichtung (2), so dass die defekte Solarzelle (220) von der ersten Solarzelle (51) getrennt wird, und Versetzen, durch die Fördervorrichtung (1), des Solarzellenstranges in eine Bewegung entlang der ersten Richtung, um zu ermöglichen, dass der vorstehende Lötstreifen (201) des zweiten Lötstreifens und die Rückseite (202) der defekten Solarzelle (220) unter der Erhitzungsvorrichtung (2) positioniert werden, und Erhitzen durch die Erhitzungsvorrichtung (2), so dass die defekte Solarzelle (220) von der zweiten Solarzelle (61) getrennt wird und der Solarzellenstrang in einen ersten Solarzellenstrang (5), der die erste Solarzelle (51) enthält, die defekte Solarzelle (220) und einen zweiten Solarzellenstrang (6), der die zweite Solarzelle (61) enthält, zerlegt wird; und
einen Schweißschritt: Versetzen, durch die Fördervorrichtung (1), des ersten Solarzellenstranges (5) und des zweiten Solarzellenstranges (6) in eine Bewegung, Anordnen einer Ersatz-Solarzelle auf der Fördervorrichtung (1), so dass die Ersatz-Solarzelle an den ersten Solarzellenstrang (5) und den zweiten Solarzellenstrang (6) stößt, Antreiben, durch die Fördervorrichtung (1), eines vorstehenden Lötstreifens (201) eines anderen Lötstreifens, der mit der Ersatz-Solarzelle verbunden ist, und der Rückseite der ersten Solarzelle (51), so dass sie unter der Erhitzungsvorrichtung (2) positioniert werden, und Erhitzen durch die Erhitzungsvorrichtung (2), um zu ermöglichen, dass die Ersatz-Solarzelle und der erste Solarzellenstrang (5) verbunden werden, Versetzen, durch die erste Förderkomponente (11), des ersten Solarzellenstranges (5) in eine Bewegung, so dass die Rückseite der Ersatz-Solarzelle unter der Erhitzungsvorrichtung (2) positioniert wird, Versetzen, durch die dritte Förderkomponente (13), des zweiten Solarzellenstranges in eine Bewegung in der ersten Richtung, so dass der vorstehende Lötstreifen des zweiten Lötstreifens unter der Erhitzungsvorrichtung (2) positioniert wird und an die Rückseite der Ersatz-Solarzelle stößt, und Erhitzen durch die Erhitzungsvorrichtung (2), um zu ermöglichen, dass die Ersatz-Solarzelle und der zweite Solarzellenstrang (6) verbunden werden.

10. Verfahren zur Reparatur eines Solarzellenstranges nach Anspruch 9, **dadurch gekennzeichnet, dass** es ferner umfasst:
einen Kombinierschritt: nachdem die erste Förderkomponente (11) den ersten Solarzellenstrang in Bewegung versetzt, um zu ermöglichen, dass die Ersatz-Solarzelle unter der Erhitzungsvorrichtung (2) positioniert wird, Versetzen, durch den Hubantrieb, der dritten Förderkomponente (13) in eine Bewegung um einen Abstand Y entlang einer vertikalen Richtung nahe an die Erhitzungsvorrichtung; und
Versetzen, durch die dritte Förderkomponente (13), des zweiten Solarzellenstranges (6) in eine Bewegung entlang der ersten Richtung nahe an den ersten Solarzellenstrang (5), bis der vorstehende Lötstreifen des zweiten Lötstreifens über der Ersatz-Solarzelle positioniert ist, und Versetzen, durch den Hubantrieb, der dritten Förderkomponente (13) in eine Bewegung um einen Abstand Y entlang einer vertikalen Richtung von der Erhitzungsvorrichtung weg, um zu ermöglichen, dass der vorstehende Lötstreifen des zweiten Lötstreifens an die Rückseite der Ersatz-Solarzelle stößt.

11. Verfahren zur Reparatur eines Solarzellenstranges nach Anspruch 10, **dadurch gekennzeichnet, dass** Y ≥ 0,3 mm ist.

12. Verfahren zur Reparatur eines Solarzellenstranges nach Anspruch 9, **dadurch gekennzeichnet, dass** ein Abstand, um den die Fördervorrichtung den Solarzellenstrang entlang der ersten Richtung in Bewegung versetzt, ein ganzzahliges Vielfaches einer orthographischen Projektion der Solarzelle entlang der ersten Richtung ist.

13. Verfahren zur Reparatur eines Solarzellenstranges nach Anspruch 9, **dadurch gekennzeichnet, dass** es ferner umfasst:
einen Ansaugschritt: wenn die erste Förderkomponente (11), die zweite Förderkomponente (12) und die dritte Förderkomponente (13) den ersten Solarzellenstrang (5), die defekte Solarzelle (220) und den zweiten Solarzellenstrang (6) in Bewegung versetzen, Aktivieren von Unterdruck-Sauglöchern an der ersten Förderkomponente (11), der zweiten Förderkomponente (12) und der dritten Förderkomponente (13) und Ansaugen des ersten Solarzellenstranges (5), der defekten Solarzelle (220) und des zweiten Solarzellenstranges (6) an diese.

14. Verfahren zur Reparatur eines Solarzellenstranges nach Anspruch 9, **dadurch gekennzeichnet, dass** es ferner umfasst:
einen Kompressionsschritt: wenn der vorstehende Lötstreifen eines anderen Lötstreifens, der mit der Ersatz-Solarzelle verbunden ist, unter der Erhitzungsvorrichtung (2) positioniert ist, Einschalten einer Kompressionsvorrichtung und Schieben des vorstehenden Lötstreifens eines anderen Lötstreifens, der mit der Ersatz-Solarzelle verbunden ist, so dass er gegen die Rückseite der ersten Solarzelle (51) gedrückt wird; und
wenn die Rückseite der Ersatz-Solarzelle unter der Erhitzungsvorrichtung (2) positioniert ist, Einschalten der Kompressionsvorrichtung und Schieben des vorstehenden Lötstreifens des zweiten Lötstreifens, so dass er gegen die Rückseite der Ersatz-Solarzelle gedrückt wird.

## Revendications

1. Dispositif de réparation d'une chaîne de cellules photovoltaïques, **caractérisé en ce qu'**il comprend :
un dispositif de transport (1) configuré pour entraîner une chaîne de cellules photovoltaïques (100) placée sur le dispositif de transport pour qu'elle effectue un mouvement de va-et-vient le long d'une première direction, dans lequel le dispositif de transport comprend un premier composant de transport (11), un deuxième composant de transport (12) et un troisième composant de transport (13) qui est disposé séparément ; et
un dispositif de cuisson (2) disposé vers le deuxième composant de transport (12),
dans lequel la chaîne de cellules photovoltaïques (100) comprend une pluralité de cellules solaires (200), des cellules solaires adjacentes de la pluralité de cellules solaires (200) sont reliées par une bande de soudure, la pluralité de cellules solaires comprend une première cellule solaire (51), une deuxième cellule solaire (61) et une cellule solaire défectueuse (220) entre la première cellule solaire (51) et la deuxième cellule solaire (61), un côté arrière (202) de la première cellule solaire (51) est fixé à une bande de soudure protubérante (201) d'une première bande de soudure, l'autre partie de la première bande de soudure est fixée à un côté avant de la cellule solaire défectueuse (220), un côté arrière (202) de la cellule solaire défectueuse (220) est fixé à une bande de soudure protubérante (201) d'une deuxième bande de soudure, et l'autre partie de la deuxième bande de soudure est fixée à un côté avant de la deuxième cellule solaire (61),
dans lequel le dispositif de transport (1) déplace la première cellule solaire (51) sur le deuxième composant de transport (12), le dispositif de cuisson (2) chauffe la première cellule solaire (51) et la bande de soudure protubérante (201) de la première bande de soudure de manière à séparer la première cellule solaire (51) et la cellule solaire défectueuse (220), le dispositif de transport (1) déplace la cellule solaire défectueuse (220) sur le deuxième élément de transport (12), le dispositif de cuisson (2) chauffe la cellule solaire défectueuse (220) et la bande de soudure protubérante (201) de la deuxième bande de soudure de manière à séparer la cellule solaire défectueuse (220) et la deuxième cellule solaire, le dispositif de transport (1) déplace la première cellule solaire (51) sur le deuxième élément de transport (12), le dispositif de cuisson (2) chauffe la première cellule solaire (51) et une bande de soudure protubérante (201) d'une autre bande de soudure, l'autre partie de la une autre bande de soudure étant fixée sur un côté avant d'une cellule solaire de remplacement, de sorte que la première cellule solaire (51) soit connectée à la cellule solaire de remplacement, le dispositif de transport (1) déplace la cellule solaire de remplacement sur le deuxième élément de transport (12), le dispositif de cuisson (2) chauffe la cellule solaire de remplacement et la bande de soudure protectrice (201) de la deuxième bande de soudure, de sorte que la cellule solaire de remplacement soit connectée à la deuxième cellule solaire (61).

2. Dispositif de réparation d'une chaîne de cellules photovoltaïques selon la revendication 1, **caractérisé en ce qu'**il comprend en outre un dispositif de fixation (3), dans lequel le dispositif de fixation (3) comprend un outil de presse (31) et un entraînement de compression (32) connectés l'un à l'autre, l'outil de presse (31) est situé entre le dispositif de cuisson (2) et le deuxième composant de transport (12), et l'outil de presse (31) est configuré pour comprimer la chaîne de cellules photovoltaïques contre la cellule solaire de remplacement à une position du bande de soudure protubérante et le côté arrière correspondant.

3. Dispositif de réparation d'une chaîne de cellules photovoltaïques selon la revendication 1, **caractérisé en ce que** le premier élément de transport (11) et/ou le troisième élément de transport (13) est équipé d'un entraînement de levage (14), l'entraînement de levage (14) est configuré pour entraîner le premier composant de transport (11) et/ou le troisième composant de transport (13) à effectuer un mouvement de va-et-vient le long d'une direction verticale, et la direction verticale est perpendiculaire à la première direction.

4. Dispositif de réparation d'une chaîne de cellules photovoltaïques selon la revendication 1, **caractérisé en ce que** le premier élément de transport (11) comprend une première plaque de base (111), une première courroie (112) disposée autour de la première plaque de base, et un premier entraînement (113) pour entraîner la première courroie (112) pour tourner autour de la première plaque de base ; ou
le deuxième composant de transport (12) comprend une deuxième plaque de base (121), une deuxième courroie (122) agencée autour de la deuxième plaque de base (121), et un deuxième entraînement (123) pour entraîner la deuxième courroie à tourner autour de la deuxième plaque de base ; ou
le troisième composant de transport (13) comprend une troisième plaque de base (131), une troisième courroie (132) disposée autour de la troisième plaque de base (131), et un troisième entraînement (133) pour entraîner la troisième courroie à tourner autour de la troisième plaque de base.

5. Dispositif de réparation de chaîne de cellules photovoltaïques selon la revendication 4, **caractérisé en ce que**, au moins une parmi la première plaque de base (111), la deuxième plaque de base (121) ou la troisième plaque de base (131) est munie d'un trou d'aspiration à pression négative (15), au moins une parmi la première courroie (111), la deuxième courroie (121) ou la troisième courroie (131) est dotée d'un via à pression négative (16) en communication avec le trou d'aspiration à pression négative (15), le trou d'aspiration à pression négative (15) est en communication avec un dispositif de pression négative externe, et le trou d'aspiration de pression négative (15) est configuré pour générer une pression négative pour aspirer la chaîne de cellules photovoltaïques (100) sur au moins la première courroie, la deuxième courroie ou la troisième courroie.

6. Dispositif de réparation d'une chaîne de cellules photovoltaïques selon la revendication 1, **caractérisé en ce que** le dispositif de cuisson (2) comprend un réchauffeur de cuisson (21) et un ascenseur de cuisson (22) reliés l'un à l'autre, l'ascenseur de cuisson (22) est configuré pour entraîner le chauffage de cuisson (21) à se déplacer le long d'une direction verticale.

7. Dispositif de réparation d'une chaîne de cellules photovoltaïques selon la revendication 6, **caractérisé en ce que** le chauffage de cuisson (21) comprend une pluralité de tubes de lampe (221) disposés séparément et espacés le long de la première direction.

8. Dispositif de réparation de chaîne de cellules photovoltaïques selon la revendication 1, **caractérisé en ce qu'**il comprend en outre un dispositif de commande (4) connecté électriquement au dispositif de transport (1) et le dispositif de cuisson (2), dans lequel le dispositif de commande (4) est configuré pour commander une course de transport et une direction de transport du dispositif de transport, et est en outre configuré pour commander la marche et l'arrêt du dispositif de cuisson (2).

9. Procédé de réparation d'une chaîne de cellules photovoltaïques, **caractérisé en ce qu'**il comprend :
une étape d'alimentation la chaîne de cellules photovoltaïques comprenant une pluralité de cellules solaires (200), les cellules solaires adjacentes de la pluralité de cellules solaires (200) étant reliées par un support de soudure, placer la chaîne de cellules photovoltaïques sur un dispositif de transport (1), et placer les côtés arrière de la pluralité de cellules solaires (200) dans la chaîne de cellules photovoltaïques sur un côté proche d'un dispositif de cuisson (2), la pluralité de cellules solaires (200) comprenant une première cellule solaire (51), une deuxième cellule solaire (61), et une cellule solaire défectueuse (220) entre la première cellule solaire (51) et la deuxième cellule solaire (61), le côté arrière (202) de la première cellule solaire (51) est fixé à un bande de soudure protubérante (201) d'une première bande de soudure, l'autre partie de la première bande de soudure est fixée à un côté avant de la cellule solaire défectueuse (220), le côté arrière (202) de la cellule solaire défectueuse (220) est fixée à une bande de soudure protubérante (201) d'une deuxième bande de soudure, et l'autre partie de la deuxième bande de soudure est fixée à un côté avant de la deuxième cellule solaire (61), le dispositif de transport (1) comprend un premier élément de transport (11), un deuxième élément de transport (12) et un troisième élément de transport (13) qui sont disposés séparément et capables d'entraîner la chaîne de cellules photovoltaïques pour qu'elle effectue un mouvement de va-et-vient le long d'une première direction, et le dispositif de cuisson (2) est disposé au-dessus du deuxième composant de transport (12) ;
une étape de dessoudage : entraîner, par le dispositif de transport (1), la chaîne de cellules photovoltaïques à se déplacer le long de la première direction pour permettre à la bande de soudure protubérante (201) de la première bande de soudure et au côté arrière (202) de la première cellule solaire (51) d'être située au-dessous du dispositif de cuisson (2), et chauffer par le dispositif de cuisson (2) de telle sorte que la cellule solaire défectueuse (220) soit déconnectée de la première cellule solaire (51), et entraîner, par le dispositif de transport (1), la chaîne de cellules photovoltaïques à se déplacer le long de la première direction pour permettre à la bande de soudure protubérante (201) de la deuxième bande de soudure et au côté arrière (202) de la cellule solaire défectueuse (220) d'être situés sous le dispositif de cuisson (2), et chauffer par le dispositif de cuisson (2), de sorte que la cellule solaire défectueuse (220) soit déconnectée de la deuxième cellule solaire (61) et que la chaîne de cellules photovoltaïques soit décomposée en une première chaîne de cellules solaires (5) comprenant la première cellule solaire (51), la cellule solaire défectueuse (220) et une deuxième chaîne de cellules solaires (6) comprenant la deuxième cellule solaire (61) ; et
une étape de soudage : entraîner, par le dispositif de transport (1), la première chaîne de cellules solaires (5) et la deuxième chaîne de cellules solaires (6), placer une cellule solaire de remplacement sur le dispositif de transport (1), de sorte que la cellule solaire de remplacement vienne en butée contre la première chaîne de cellules solaires (5) et la deuxième chaîne de cellules solaires (6), entraîner, par le dispositif de transport (1), une bande de soudure protubérante (201) d'une autre bande de soudure connectée à la cellule solaire de remplacement et le côté arrière de la première cellule solaire (51) à être situés au-dessous du dispositif de cuisson (2), et chauffer par le dispositif de cuisson (2) pour permettre à la cellule solaire de remplacement et à la première chaîne de cellules solaires (5) d'être connecté, entraîner, par le premier composant de transport (11), la première chaîne de cellules solaires (5) à se déplacer, de sorte que le côté arrière de la cellule solaire de remplacement soit situé au-dessous du dispositif de cuisson (2), entraîner, par le troisième composant de transport (13), la deuxième chaîne de cellules solaires à se déplacer dans la première direction, de sorte que la bande de soudure protubérante de la deuxième bande de soudure soit située au-dessous du dispositif de cuisson (2) et bute contre le côté arrière de la cellule solaire de remplacement, et chauffer par le dispositif de cuisson (2) pour permettre à la cellule solaire de remplacement et à la deuxième chaîne de cellules solaires (6) d'être connectées.

10. Procédé de réparation d'une chaîne de cellules photovoltaïques selon la revendication 9, **caractérisé en ce qu'**il comprend en outre :
une étape de combinaison : après que le premier élément de transport (11) entraîne le déplacement de la première chaîne de cellules solaires pour permettre à la cellule solaire de remplacement d'être située sous le dispositif de cuisson (2), entraîner, par l'entraînement de levage, le troisième composant de transport (13) pour qu'il se déplace d'une distance Y le long d'une direction verticale proche du dispositif de cuisson ; et
entraîner, par le troisième composant de transport (13), la deuxième chaîne de cellules solaires (6) à se déplacer le long de la première direction à proximité de la première chaîne de cellules solaires (5), jusqu'à ce que la bande de soudure protubérante de la deuxième bande de soudure soit située au-dessus de la cellule solaire de remplacement, et entraîner, par l'entraînement de levage, le troisième composant de transport (13) à se déplacer d'une distance Y le long d'une direction verticale à l'opposé du dispositif de cuisson, pour permettre à la bande de soudure protubérante de la deuxième bande de soudure de venir en butée contre l'arrière de la cellule solaire de remplacement.

11. Procédé de réparation d'une chaîne de cellules photovoltaïques selon la revendication 10, **caractérisé en ce que** Y ≥ 0,3 mm.

12. Procédé de réparation d'une chaîne de cellules photovoltaïques selon la revendication 9, **caractérisé en ce que** la distance sur laquelle le dispositif de transport entraîne le chaîne de cellules photovoltaïques à se déplacer dans la première direction est un multiple entier d'une projection orthographique de la cellule solaire le long de la première direction.

13. Procédé de réparation d'une chaîne de cellules photovoltaïques selon la revendication 9, **caractérisé en ce qu'**il comprend en outre :
une étape d'aspiration : lorsque le premier élément de transport (11), le deuxième élément de transport (12) et le troisième élément de transport (13) entraînent la première chaîne de cellules solaires (5), la cellule solaire défectueuse (220) et la deuxième chaîne de cellules solaires (6) à se déplacer, activer des trous d'aspiration à pression négative sur le premier composant de transport (11), le deuxième composant de transport (12) et le troisième composant de transport (13) et aspirer la première chaîne de cellules solaires (5), la cellule solaire défectueuse (220) et la deuxième chaîne de cellules solaires (6) dessus.

14. Procédé de réparation d'une chaîne de cellules photovoltaïques selon la revendication 9, **caractérisé en ce qu'**il comprend en outre :
une étape de compression : lorsque la bande de soudure protubérante d'une autre bande de soudure connectée à la cellule solaire de remplacement est située en dessous du dispositif de cuisson (2), démarrer une compression et pousser la bande de soudure protubérante d'une autre bande de soudure connectée à la cellule solaire de remplacement pour la comprimer contre le côté arrière de la première cellule solaire (51) ; et
lorsque le côté arrière de la cellule solaire de remplacement est située sous le dispositif de cuisson (2), démarrer le dispositif de compression et pousser la bande de soudure protubérante de la deuxième bande de soudure à comprimer contre le côté arrière de la cellule solaire de remplacement.
